# EUROPEAN PATENT APPLICATION

(11) **EP 4 589 307 A1**
(43) Date of publication of application: **23.07.2025**
(21) Application number: 23864978.4
(22) Date of filing: 11.05.2023
(51) Int. Cl.: G01R 1/073, G01R 1/067, G01R 31/26, H01L 21/66

(54) **ELECTRICAL CONNECTION DEVICE**

(30) Priority: 14.09.2022 JP 2022146297
(71) Applicant: Kabushiki Kaisha Nihon Micronics, Musashino-shi Tokyo 180-8508 (JP)
(72) Inventor: HAYASHIZAKI Takayuki, Musashino-shi, Tokyo 180-8508 (JP); MURAMOTO Tsuyoshi, Musashino-shi, Tokyo 180-8508 (JP); SUTO Kenichi, Musashino-shi, Tokyo 180-8508 (JP); KON Mizuho, Musashino-shi, Tokyo 180-8508 (JP); NASU Mika, Musashino-shi, Tokyo 180-8508 (JP); TOYODA Misaki, Musashino-shi, Tokyo 180-8508 (JP)
(74) Representative: Samson & Partner Patentanwälte mbB
(86) International application number: PCT/JP2023/017750
(87) International publication number: WO 2024/057613

(57) **Abstract**

An electrical connection apparatus includes probes; and a probe head having a configuration in which a first guide plate and a second guide plate, each having a guide hole formed therein, are arranged apart from each other along a surface normal direction of a main surface of the first guide plate. Positions of the guide hole of the first guide plate and the guide hole of the second guide plate through which the same probe penetrates are arranged so as to be shifted parallel to a main surface of the first guide plate. A direction in which the positions of the guide holes are shifted intersects obliquely with an arrangement direction of inspection pads of an inspection object.

## Description

### TECHNICAL FIELD

The present invention relates to an electrical connection apparatus used for measuring the electrical characteristics of an inspection object.

### BACKGROUND

In order to measure the electrical characteristics of an inspection object such as an integrated circuit without being separated from a wafer, an electrical connection apparatus which includes probes brought into contact with the inspection object and a probe head holding the probes has been used (see Patent Literature 1). In the electrical connection apparatus, the probe head having a plurality of guide plates provided with a hollow portion between the guide plates has been used. The probes penetrate through guide holes formed in the guide plates and are held by the probe head in a state in which the probes are curved in the hollow portion.

### CITATION LIST

### PATENT LITERATURE

Patent Literature 1: JP 2015-118064 A

### SUMMARY OF THE INVENTION

### TECHNICAL PROBLEM

In the electrical connection apparatus, the probes are arranged at positions corresponding to inspection pads of an inspection object. Accordingly, when a distance between the inspection pads becomes small due to the miniaturization of the inspection object, a distance between the probes also becomes small. In a case where the distance between the probes becomes small, when the probes are curved inside the hollow portion of the probe head at the time of an inspection of the inspection object, a problem occurs in which the adjacent probes come into contact with each other, causing the probes to short circuit.

In view of the above problem, an object of the present invention is to provide an electrical connection apparatus capable of suppressing a short circuit between probes.

### TECHNICAL SOLUTION

According to an aspect of the present invention, there is provided an electrical connection apparatus including: probes; and a probe head having a first guide plate and a second guide plate each of which has a guide hole formed therein. The probe head has a configuration in which the first guide plate and the second guide plate are arranged apart from each other along a surface normal direction of a main surface of the first guide plate. Positions of the guide hole of the first guide plate and the guide hole of the second guide plate through which the same probe penetrates are arranged so as to be shifted parallel to the main surface of the first guide plate. A direction in which the positions of the guide holes are shifted intersects obliquely with an arrangement direction of inspection pads.

### EFFECT OF THE INVENTION

The present invention makes it possible to provide an electrical connection apparatus capable of suppressing a short circuit between probes.

### BRIEF DESCRIPTION OF DRAWINGS

[FIG. 1] FIG. 1 is a schematic diagram illustrating a configuration of an electrical connection apparatus according to a first embodiment of the present invention.
[FIG. 2] FIG. 2 is a schematic diagram illustrating a relationship between a cross-sectional shape of a probe and an offset direction of the electrical connection apparatus according to the first embodiment of the present invention.
[FIG. 3] FIG. 3 is a schematic diagram illustrating a relationship between a shape of a guide hole and an offset direction of the electrical connection apparatus according to the first embodiment of the present invention.
[FIG. 4] FIG. 4 is a schematic diagram illustrating an arrangement example of inspection pads of an inspection object.
[FIG. 5] FIG. 5 is a schematic diagram illustrating a distance between probes in a probe head of a comparative example.
[FIG. 6] FIG. 6 is a schematic diagram illustrating a distance between probes in a probe head of the electrical connection apparatus according to the first embodiment of the present invention.
[FIG. 7] FIG. 7 is a schematic diagram illustrating an example of a shape of a guide hole in the electrical connection apparatus according to the first embodiment of the present invention.
[FIG. 8] FIG. 8 is a schematic diagram illustrating another example of the shape of the guide hole of the electrical connection apparatus according to the first embodiment of the present invention.
[FIG. 9A] FIG. 9A is a schematic cross-sectional diagram illustrating an example of a shape of an opening of the guide hole of the electrical connection apparatus according to the first embodiment of the present invention.
[FIG. 9B] FIG. 9B is a schematic cross-sectional diagram illustrating another example of the shape of the opening of the guide hole of the electrical connection apparatus according to the first embodiment of the present invention.
[FIG. 10] FIG. 10 is a schematic diagram illustrating an arrangement example of the inspection pads of the inspection object.
[FIG. 11] FIG. 11 is a schematic diagram illustrating an arrangement example of the guide holes of the electrical connection apparatus according to the first embodiment of the present invention corresponding to the arrangement of the inspection pads illustrated in FIG. 10.
[FIG. 12] FIG. 12 is a schematic diagram illustrating a configuration of an electrical connection apparatus according to a second embodiment of the present invention.
[FIG. 13] FIG. 13 is a schematic diagram for explaining an example in which the probes come into contact with each other.
[FIG. 14] FIG. 14 is a schematic cross-sectional diagram illustrating a covering material arranged on a probe of the electrical connection apparatus according to the second embodiment of the present invention.

### DETAILED DESCRIPTION OF THE INVENTION

Embodiments of the present invention will be described below with reference to the drawings. The same or similar elements illustrated in the drawings are denoted by the same or similar reference numerals. However, the drawings are illustrated schematically, and it should be noted that the proportions of the thicknesses or lengths of the respective parts and so forth are not drawn to scale. It should also be understood that the relationships or proportions of the dimensions between the respective drawings are different from each other in some elements. The embodiments described below exemplify a device and a method for embodying a technical idea of the present invention. In the embodiments of the present invention, the material, shape, structure, arrangement, manufacturing method and the like of the components are not limited to the following description.

### (First Embodiment)

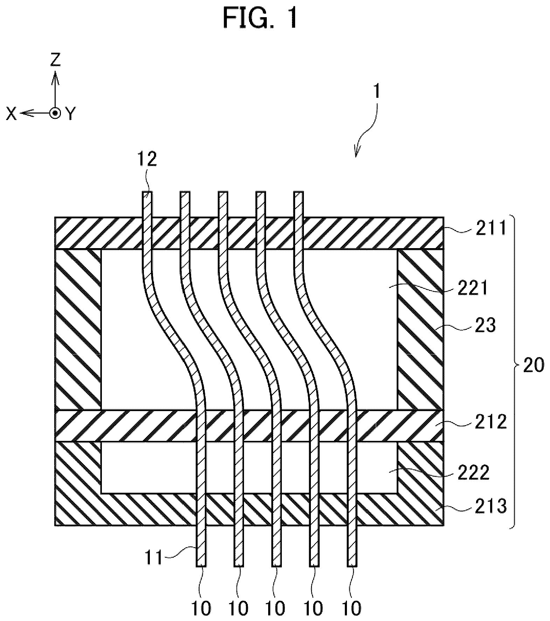

As illustrated in FIG. 1, an electrical connection apparatus 1 according to the first embodiment includes a plurality of probes 10 and a probe head 20 that holds the probes 10. The probes 10 come into contact with an inspection object at the time of an inspection of the inspection object. Hereinafter, one end of the probe 10 coming into contact with the inspection object is referred to as a "tip end 11" and the other end thereof is referred to as a "base end 12". The tip end 11 comes into contact with an inspection pad arranged on the inspection object, for example. The base end 12 is connected to an electrode arranged on a printed circuit board (not illustrated), for example. An electrode of the printed circuit board is electrically connected to an inspection device such as a tester. An electric signal propagates between the inspection device and the inspection object through the electrical connection apparatus 1.

The probe head 20 has a first guide plate 211, a second guide plate 212, and a third guide plate 213. The first guide plate 211, the second guide plate 212, and the third guide plate 213 are arranged in multiple stages apart from each other along the surface normal direction of the main surface of the first guide plate 211. A region near the base end 12 of the probe 10 penetrates through the first guide plate 211. A region near the tip end 11 of the probe 10 penetrates through the third guide plate 213. The second guide plate 212 is arranged between the first guide plate 211 and the third guide plate 213, and an intermediate part of the probe 10 between the tip end 11 and the base end 12 penetrates through the second guide plate 212.

Hereinafter, when the first guide plate 211, the second guide plate 212, and the third guide plate 213 are not individually limited, they are collectively referred to as a guide plate 21. The guide holes (not illustrated in FIG. 1) are formed in the portions of the guide plate 21 through which the probes 10 penetrate. In other words, the probe head 20 holds the probes 10 in a state in which the probes 10 penetrate through the guide holes respectively formed in the guide plate 21. The first guide plate 211, the second guide plate 212, and the third guide plate 213 may be referred to as a "top guide plate", a "middle guide plate", and a "bottom guide plate", respectively.

The probe head 20 has a first hollow portion 221 that is arranged between the first guide plate 211 and the second guide plate 212, and a second hollow portion 222 that is arranged between the second guide plate 212 and the third guide plate 213. In the probe head 20 illustrated in FIG. 1, the first hollow portion 221 is formed by disposing a spacer 23 between the outer edge of the first guide plate 211 and the outer edge of the second guide plate 212. Further, the second hollow portion 222 is formed by providing a concave portion in the main surface of the third guide plate 213 opposed to the second guide plate 212. Needless to say, a method of forming the first hollow portion 221 and the second hollow portion 222 is not limited to the above-described methods.

In the description of the embodiments of the present invention, the X direction, the Y direction, and the Z direction are defined as illustrated in FIG. 1. In FIG. 1, the X direction is the left-right direction of the page space, the Y direction is the depth direction of the page space, and the Z direction is the up-down direction of the page space. In the Z direction, the direction in which the first guide plate 211 is positioned as viewed from the third guide plate 213 is the upward direction, and the direction in which the third guide plate 213 is positioned as viewed from the first guide plate 211 is the downward direction. The main surface of the guide plate 21 facing upward is also referred to as the upper surface, and the main surface thereof facing downward is also referred to as the lower surface. That is, the surface normal direction of the upper surface and lower surface of the guide plate 21 is the Z direction. The guide holes penetrate from the upper surface to the lower surface of the guide plate 21. The upper surface and lower surface of the guide plate 21 are parallel to the XY plane defined by the X direction and Y direction.

As viewed from the surface normal direction (Z direction) of the main surface of the first guide plate 211, the positions of the guide hole of the first guide plate 211 and the guide hole of the second guide plate 212 through which the same probe 10 penetrates are arranged so as to be shifted parallel to the main surface of the first guide plate 211. Hereinafter, an arrangement in which the positions of the guide holes are shifted parallel to the main surface of the first guide plate 211 is referred to as an "offset arrangement". In the offset arrangement, the direction in which the position of the guide hole 220 of the first guide plate 211 and the position of the guide hole 220 of the second guide plate 212 are shifted is referred to as an "offset direction". In the probe head 20 illustrated in FIG. 1, the offset direction is parallel to the X direction.

An elastic material having conductivity is used for the probes 10. The probes 10 have elasticity, and thus the probes 10 are curved by elastic deformation inside the first hollow portion 221 provided between the first guide plate 211 and the second guide plate 212 when the guide hole of the first guide plate 211 and the guide hole of the second guide plate 212 are arranged in an offset manner. In other words, the probe head 20 holds the curved probes 10.

By arranging the first guide plate 211 and the second guide plate 212 in an offset manner, the respective probes 10 are curved together such that the arc-shaped outer sides protrude in the offset direction. In other words, the probes 10 extend in the offset direction as viewed from the Z direction. That is, the probe head 20 controls the curved direction of the probes 10 by means of the offset arrangement. Hereinafter, the surface of the curved probe 10 facing the offset direction is also referred to as an "offset surface". In addition, the surface opposite to the offset surface of the probes 10 is also referred to as an "opposite surface".

Since the probes 10 are held by the probe head 20 in a curved state, when the tip ends 11 of the probes 10 come into contact with the inspection object in a state in which the positions of the base ends 12 are fixed, the probes 10 are curved more greatly in the first hollow portion 221. That is, at the time of an inspection of the inspection object, the probes 10 buckle between the first guide plate 211 and the second guide plate 212 due to deflection deformation.

From the non-contact state in which the probes 10 are not in contact with the inspection object, in the contact state in which the probes 10 are in contact with the inspection object, the probes 10 are further curved, and thus the probes 10 come into contact with the inspection object at a predetermined pressure. Therefore, the offset arrangement makes it possible to measure the electrical characteristics of the inspection object stably using the probes 10. Since each of the probes 10 passes through the second guide plate 212, it is possible to prevent the adjacent probes 10 from coming into contact with each other in the first hollow portion 221.

In the probe head 20, the positions of the guide hole of the second guide plate 212 and the guide hole of the third guide plate 213 substantially coincide with each other as viewed from the Z-direction. Therefore, inside the second hollow portion 222 provided between the second guide plate 212 and the third guide plate 213, the probes 10 extend linearly to the lower surface of the third guide plate 213 in the surface normal direction. As a result, the tip ends of the probes 10 stably come into contact with the inspection pads of the inspection object.

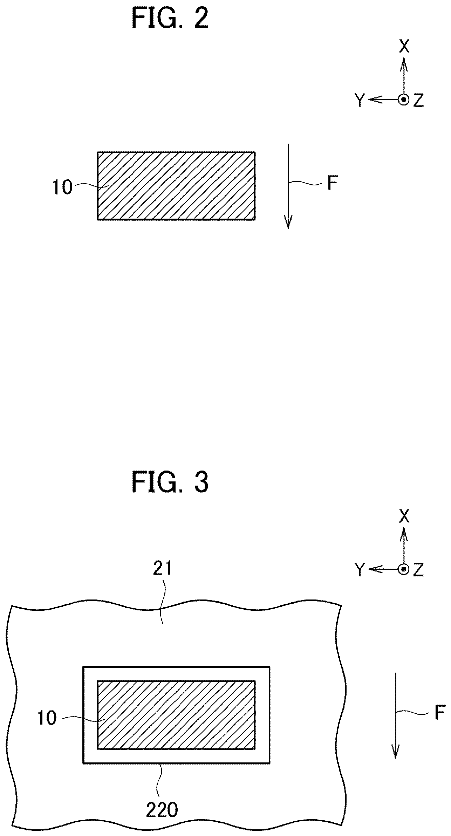

In order to curve the probe 10 in a desired direction by means of the offset arrangement, it is preferred that the cross-section perpendicular to the central axis direction of the probe 10 (hereinafter, it is simply referred to as "cross-section") has a shape including linear sides perpendicular to the offset direction. For example, the probe 10 may have a rectangular cross-sectional shape. When the probe 10 has a rectangular cross-sectional shape, it is preferred that the sides perpendicular to the offset direction F is the long sides, and the sides parallel to the offset direction is the short sides, as illustrated in FIG. 2. By making the sides perpendicular to the offset direction F be the long sides, all the probes 10 held by the probe head 20 can be aligned and curved in a certain direction. Here, the direction in which the position of the guide hole of the second guide plate 212 is shifted as viewed from the guide hole of the first guide plate 211 is defined as the offset direction F (the same shall apply hereinafter).

In the guide hole formed in the guide plate 21, it is preferred that the shape of the guide hole (hereinafter, simply referred to as "shape") viewed from the Z direction is similar to the cross-sectional shape of the probe 10 in order to suppress the probe 10 to be shifted in the XY plane inside the guide hole. Therefore, the linear sides perpendicular to the offset direction F are also included in the guide hole through which the probe 10 having the sides perpendicular to the offset direction F penetrates. In addition, the longitudinal direction in the shape of the guide hole is perpendicular to the offset direction F. For example, the guide hole 220 through which the probe 10 illustrated in FIG. 2 passes may have a rectangular shape as illustrated in FIG. 3. As illustrated in FIG. 3, the long side direction of the guide hole 220 viewed from the Z direction is perpendicular to the offset direction F.

The probe 10 has elasticity to return to the shape before coming into contact with the inspection object when the probe 10 and the inspection object are in a non-contact state. Tungsten (W) or the like is used as the material of the probe 10. Alternatively, copper (Cu) alloy, palladium (Pd) alloy, nickel (Ni) alloy, and W alloy may be used as the material of the probe 10. A ceramic material or the like is suitably used as the material of the guide plate 21 of the probe head 20. For example, silicon nitride ceramic or the like may be used as the material of the guide plate 21.

As described below, in the electrical connection apparatus 1, the offset direction intersects obliquely with the arrangement direction of the inspection pads of the inspection object 2 as viewed from the Z direction. Since the offset direction intersects obliquely with the arrangement direction of the inspection pads, the distance between the adjacent probes 10 in the curved direction (offset direction) can be increased. An angle formed by the arrangement direction of the inspection pads and the offset direction is 45 degrees, for example.

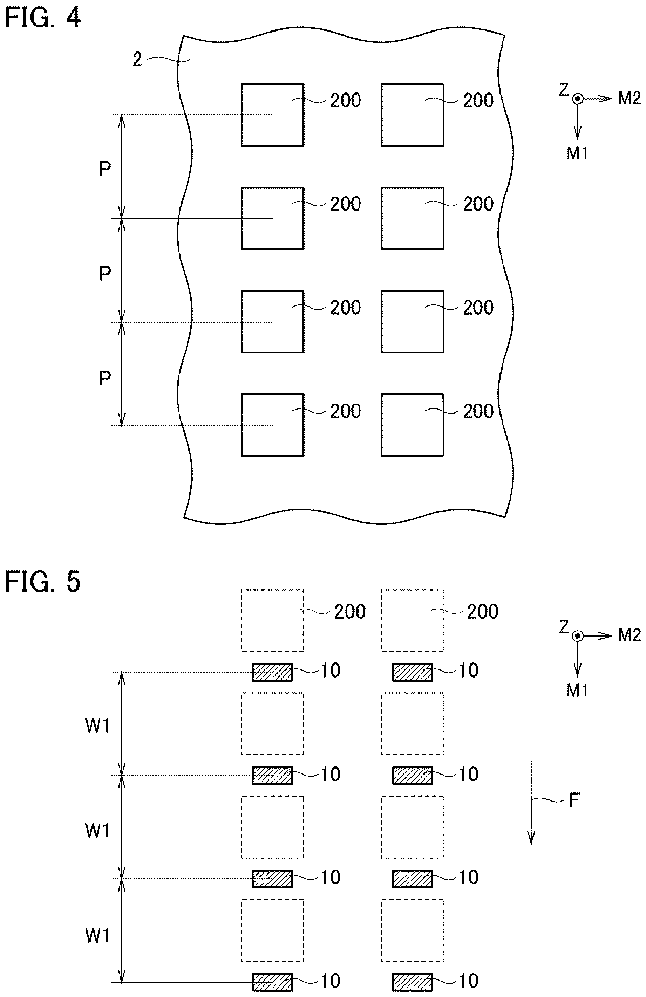

In a case where the plurality of inspection pads 200 of the inspection object 2 are arranged in a matrix as viewed from the Z direction as illustrated in FIG. 4, the distance between the probes 10 will be discussed. The inspection pads 200 are arranged in a matrix along a first direction M1 and a second direction M2 orthogonal to the first direction M1, as viewed from the Z direction. The plane defined by the first direction M1 and the second direction M2 is parallel to the XY plane. As illustrated in FIG. 4, the distance between the inspection pads 200 in the first direction M1 is a pitch P. The distance between the inspection pads 200 is a distance between the centers of the inspection pads 200.

FIG. 5 illustrates a distance W1 between the probes 10 in the probe head 20A of the comparative example in which the offset direction F is the first direction M1. The distance between the probes 10 is a distance between the centers of the probes 10 along the offset direction F (the same shall apply hereinafter). As illustrated in FIG. 5, the distance W1 between the probes 10 held by the probe head 20A of the comparative example along the offset direction F is about the same as the pitch P which is the distance between the inspection pads 200 in the first direction M1.

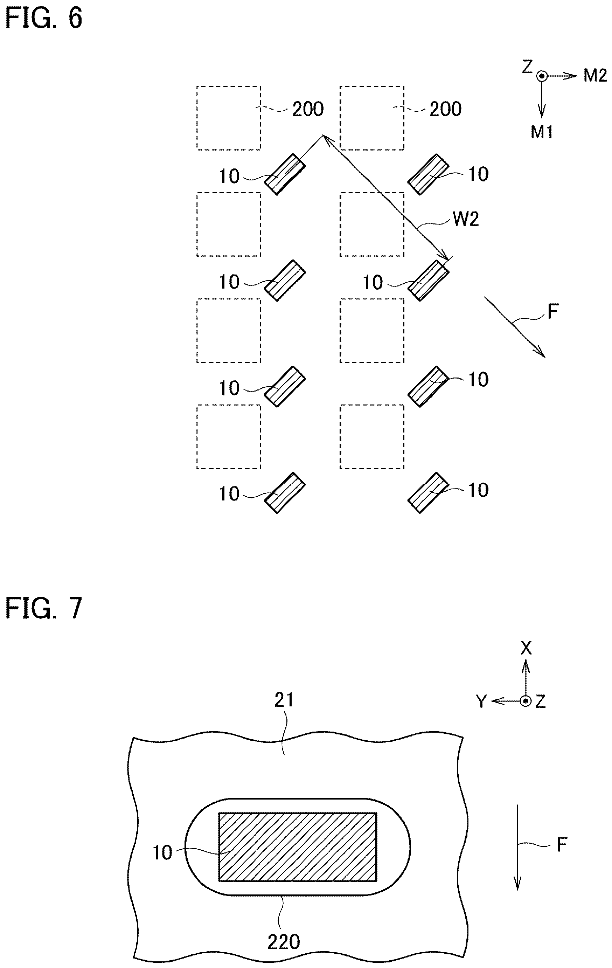

FIG. 6 illustrates a distance W2 between the probes 10 in the probe head 20 of the electrical connection apparatus 1. As illustrated in FIG. 6, the offset direction F of the probe head 20 intersects obliquely with both the first direction M1 and the second direction M2 which are the arrangement directions of the inspection pads 200. As a result, as illustrated in FIG. 6, the distance W2 between the probes 10 along the offset direction F can be made larger than the pitch P between the inspection pads 200.

As described above, in the probe head 20, the distance in the direction in which the adjacent probes 10 are curved is larger than that in the comparative example in which the arrangement direction of the inspection pads 200 and the offset direction F are the same, while the distance between the inspection pads 200 is maintained. In other words, according to the electrical connection apparatus 1 in which the offset direction intersects obliquely with the arrangement direction of the inspection pads 200, the distance between the probes 10 along the offset direction F can be increased without increasing the distance between the inspection pads 200. According to the probe head 20 in which the distance between the probes 10 along the offset direction F can be increased as described above, the distance between the probes 10 in the state in which the probes 10 buckle becomes small, thereby suppressing the contact between the probes 10.

As described above, in the electrical connection apparatus 1 according to the first embodiment, the arrangement direction of the inspection pads 200 intersects obliquely with the offset direction. Therefore, the electrical connection apparatus 1 makes it possible to suppress the contact between the adjacent probes 10 when the probes 10 are curved. This makes it possible to prevent a short circuit between the probes 10 due to the contact between the adjacent probes 10 (hereinafter, it is also referred to simply as a "short circuit between the probes").

An example in which the guide hole 220 has a rectangular shape is illustrated in FIG. 3, but the shape of the guide hole 220 is not limited to a rectangular shape. For example, the guide hole 220 may have a trapezoidal shape, a parallelogram shape, or a square shape. In addition, the guide hole 220 may have a rectangular shape in which the corners are R chamfered. Alternatively, the guide hole 220 may have an elliptical shape as illustrated in FIG. 7. In the guide hole 220 illustrated in FIG. 7, the major axis direction is perpendicular to the offset direction F, and the minor axis direction is parallel to the offset direction F. In other words, even when the guide hole 220 has an elliptical shape, the longitudinal direction of the guide hole 220 is perpendicular to the offset direction.

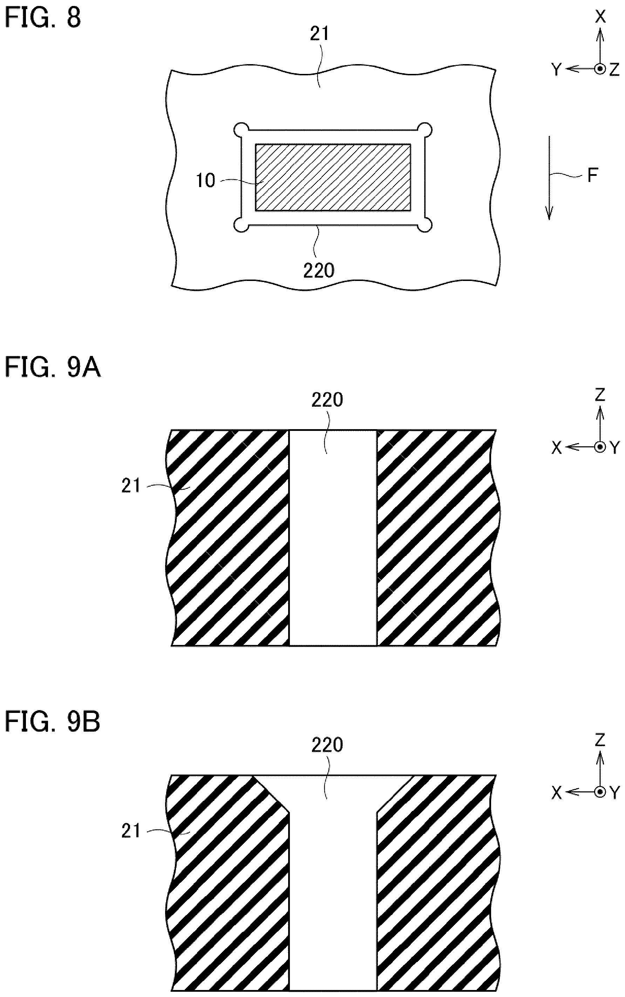

Alternatively, as illustrated in FIG. 8, the guide hole 220 may has a rectangular shape with relief processing (relief corner) that widens the corners. By forming the relief corner at the corners of the guide hole 220, damage to the probe 10 and the guide plate 21 caused by the contact between the corners of the guide hole 220 and the probe 10 can be suppressed.

In addition, the opening of the guide hole 220 in the cross-section along the thickness direction of the guide plate 21 may be formed vertically as illustrated in FIG. 9A, or formed into a tapered shape in which the diameter of the opening gradually changes as illustrated in FIG. 9B. In other words, even if the cross-sectional shape of the opening of the guide hole 220 changes due to the processing method for forming the guide hole 220 in the guide plate 21, the effect of the electrical connection apparatus 1 is not affected.

### <Modification example>

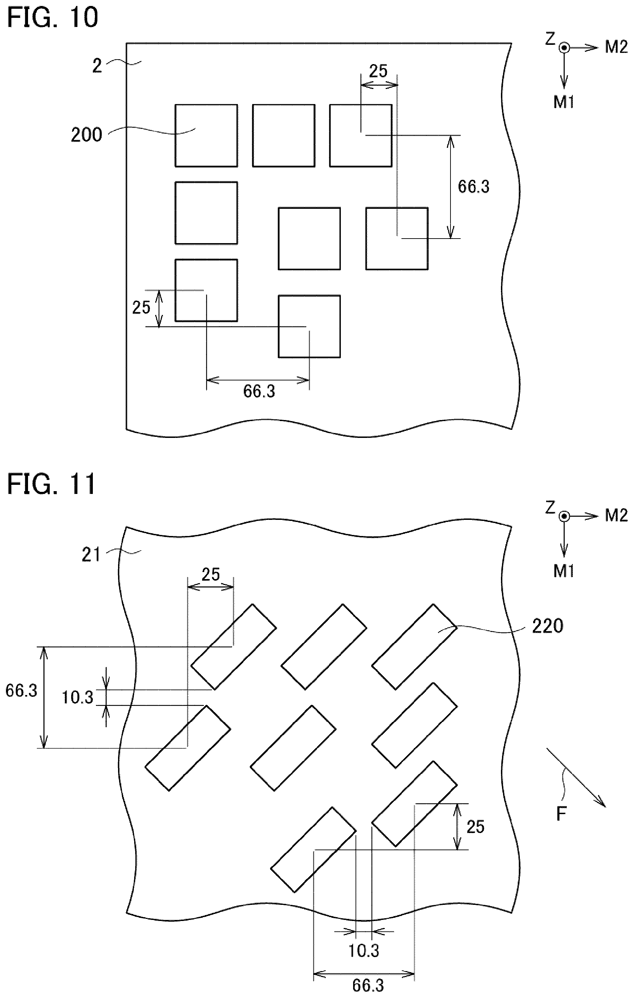

Although FIG. 6 illustrates an example in which the inspection pads 200 are arranged in a matrix shape, the electrical connection apparatus 1 according to the first embodiment can be applied even if the inspection pads 200 are not arranged in a matrix shape. For example, the inspection pads 200 may be arranged in a staggered manner. FIG. 10 illustrates an arrangement example of the inspection pads 200 at the corner portion in the arrangement region of the inspection pads 200 when the inspection pads 200 are arranged in a staggered manner. The unit of the numerical size in the figure is µm. Regarding the arrangement example illustrated in FIG. 10, in the arrangement region of the inspection pads 200, the inner inspection pads 200 are arranged so as to be shifted from the outer inspection pads 200 along the first direction M1 and the second direction M2.

FIG. 11 illustrates an arrangement example of the guide holes 220 corresponding to the arrangement of the inspection pads 200 illustrated in FIG. 10. As illustrated in FIG. 11, even when the inspection pads 200 arranged in a staggered manner, a short circuit between the probes due to the contact between the adjacent probes 10 can be suppressed by making the offset direction F oblique to the arrangement direction of the inspection pads 200.

### (Second Embodiment)

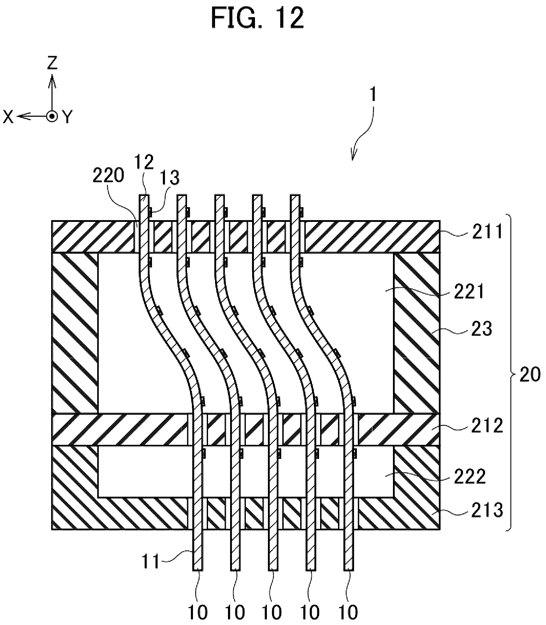

In the electrical connection apparatus 1 according to a second embodiment of the present invention, as illustrated in FIG. 12, a plurality of insulating covering materials 13 are arranged on the surface of the probe 10. The covering materials 13 are arranged apart from each other along the central axis direction of the probe. The electrical connection apparatus 1 illustrated in FIG. 12 differs from the electrical connection apparatus 1 according to the first embodiment in that the covering materials 13 are arranged on the surface of the probe 10. In the other configurations, the electrical connection apparatus 1 according to the second embodiment is the same as that of the first embodiment. For example, the offset direction in the offset arrangement of the positions of the guide holes of the guide plate 21 intersects obliquely with the arrangement direction of the inspection pads.

Even in a case where the positions of the guide holes of the guide plate 21 are arranged in an offset manner, when the probes 10 buckle inside the first hollow portion 221 of the probe head 20 at the time of an inspection of the inspection object, a short circuit between the probes may occur. The electrical connection apparatus 1 illustrated in FIG. 12 prevents a short circuit between the probes caused by buckling of the probe 10 by bringing the insulating covering materials 13 arranged on the surface of the probe 10 into contact with the adjacent probe 10.

In order to prevent a short circuit between the probes when the probes 10 buckle, it is conceivable that the covering material 13 may be arranged only on the offset surface or opposite surface of the probes 10. However, in the case of the probes 10 in which the covering material 13 is arranged only on one surface, the surfaces of the probes 10 on which the covering material 13 is not arranged may come into contact with each other when the distance between the probes 10 becomes smaller than a predetermined distance, or when the probes 10 are curved in such a way as to be deviated from the offset direction. For example, due to the difference (clearance) between the outer diameters of the probes 10 and the inner diameters of the guide holes, the positions of the probes 10 may become unstable inside the guide holes. Since the positions of the probes 10 become unstable, the probes 10 are not curved accurately in the offset direction, and thus the surface of the probe 10 on which the covering material 13 is not arranged may come into contact with the surface of the adjacent probe 10 on which the covering material 13 is not arranged. As a result, a short circuit between the probes occurs.

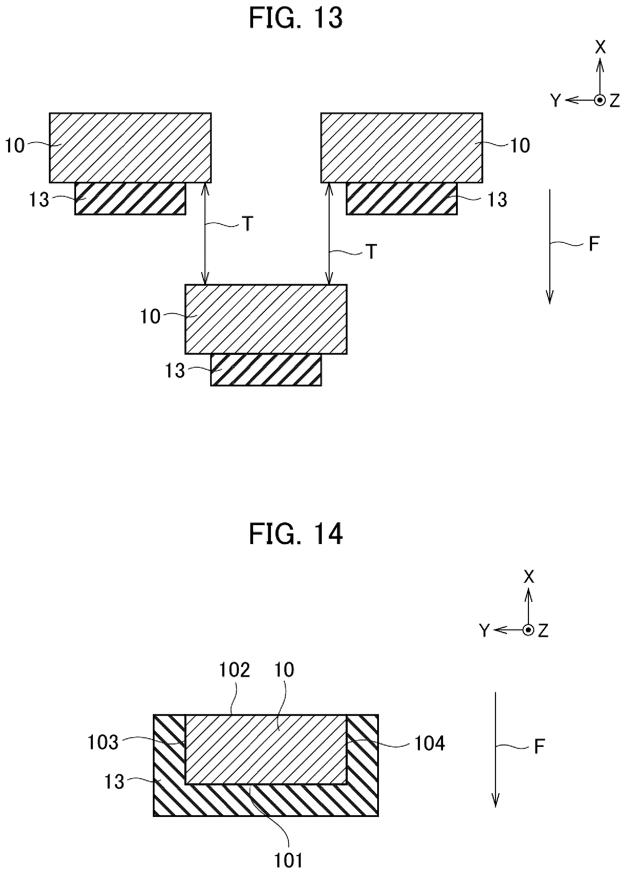

Alternatively, when the distance between the probes 10 is specified, the surfaces of the probes 10 on which the covering material 13 is not arranged may come into contact with each other. For example, as illustrated in FIG. 13, when the distance between the probes 10 in the direction perpendicular to the offset direction F is small, the outer edge of the offset surface of the probe 10 on which the covering material 13 is not arranged may come into contact with the opposite surface of the adjacent probe 10 as indicated by the arrow T. As a result, a short circuit between the probes occurs.

As described above, in the probes 10 in which the covering material 13 is arranged only on the offset surface or the opposite surface, a short circuit between the probes may occur. In order to prevent such a short circuit between the probes, it is preferred that the covering material 13 is also arranged on the side surfaces of the probes 10 connected to the offset surface. For example, in the probe 10 illustrated in FIG. 14 having a rectangular cross-section defined by an offset surface 101, an opposite surface 102, and a first side surface 103 and a second side surface 104 connected to the offset surface 101 and the opposite surface 102, the covering material 13 is continuously arranged on the three side surfaces. In the probe 10 illustrated in FIG. 14, the covering material 13 is arranged on the offset surface 101 of the probe 10, and on the first side surface 103 and the second side surface 104 connected to the offset surface. In other words, the covering material 13 is continuously arranged on the surface of the probe 10 from the first side surface 103 through the offset surface 101 to the second side surface 104. In the probe 10 illustrated in FIG. 14, even if the probes come into contact with each other, a short circuit between the probes is prevented by the covering material 13.

As illustrated in FIG. 12, the covering materials 13 are intermittently arranged on the portions passing through the first hollow portion 221 of the probes 10, including at least the curved portions. In contrast, when the surface of the probe 10 is continuously covered with the covering materials 13 from the tip end 11 to the base end 12 along the central axis direction, the probe 10 tends to warp. However, in the probes 10 illustrated in FIG. 12, the warpage of the probes 10 is suppressed by intermittently arranging the covering materials 13 along the central axis direction. Therefore, the distance between the covering materials 13 along the axis direction is set such that and the number of portions where the probes are short-circuited by the contact between the probes 10 is as small as possible in addition to suppressing the warpage of the probes 10. The plurality of covering materials 13 are arranged apart from each other on the surfaces of the probes 10 in accordance with the set distance.

Meanwhile, in order to set the probe 10 to the probe head 20, the probe 10 is made to penetrate through the guide hole 220 of the guide plate 21. For example, the probe 10 is made continuously to penetrate through the guide hole 220 of the guide plate 21 with the central axes of the guide holes 220 of all the guide plates 21 aligned. Therefore, a sum of the outer diameter of the probe 10 and the thickness of the covering material 13 is set smaller than the inner diameter of the guide hole 220.

The material of the covering material 13 may be, for example, resin, glass fiber, permanent resist, ceramic vapor deposition, or the like. In order to form the covering material 13 at a predetermined position on the surface of the probe 10, for example, the covering material 13 may be patterned using a photolithography technique or the like after the covering material 13 is formed on the surface of the probe 10.

A short circuit between the probes is more likely to be prevented as the distance between the covering materials 13 along the central axis direction is smaller. The length of the covering materials 13 in the central axis direction and the distance between the covering materials 13 in the central axis direction can optionally be set according to the thickness of the probes 10 and the material of the probes 10 within a range that does not cause the warpage of the probes 10. For example, the covering materials 13 are arranged on the surface of the probe 10 at a distance of 50 µm. The thickness of the covering materials 13 is set to a thickness with which it is possible to prevent a short circuit between the probes within a range that ensures a clearance between a sum of the outer diameter of the probe 10 and the thickness of the covering materials 13, and the inner diameter of the guide hole 220.

As described above, in the electrical connection apparatus 1 according to the second embodiment, a short circuit between the probes can be suppressed by arranging the covering materials 13 on the surface of the probe 10 in addition to the arrangement direction of the inspection pads 200 and the offset direction intersecting obliquely with each other. Except for this feature, the electrical connection apparatus 1 according to the second embodiment is the same as that of the first embodiment, and a redundant description will be omitted.

### (Other embodiments)

The embodiments of the present invention have been described above, but the statements and drawings forming part of this disclosure should not be understood as limiting the invention. Various alternative embodiments, examples, and operating techniques will be apparent to those skilled in the art from this disclosure.

For example, the case where the probe 10 has a rectangular cross-sectional shape has been described above, but the probe 10 may have a different cross-sectional shape. For example, the probe 10 may have a polygonal cross-sectional shape other than a rectangular cross-sectional shape. In addition, the case where the probe head 20 has three guide plates 21 has been described above, but the probe head 20 may have four or more guide plates 21.

Further, in the second embodiment, the covering material 13 is arranged on the offset surface 101, the first side surface 103, and the second side surface 104 of the probe 10 having a rectangular cross-section, but the covering material 13 may be arranged on four surfaces of the probe 10 including the opposite surface 102. Alternatively, the covering material 13 may be continuously arranged on three surfaces of the opposite surface 102, the first side surface 103, and the second side surface 104 of the probe 10. In addition, when only one side surface of the probe 10 may be in contact with the adjacent probe 10 due to the distance between the probes or the like, the covering material 13 may be arranged on two side surfaces of the side surface that may be in contact with the adjacent probe 10 and the offset surface or the opposite surface.

Thus, the present invention will of course include various embodiments and the like which are not described herein.

### REFERENCE SIGNS LIST

1: Electrical connection apparatus
2: Inspection object
10: Probe
11: Tip end
12: Base end
13: Covering material
20: Probe head
21: Guide plate
211: First guide plate
212: Second guide plate
213: Third guide plate
220: Guide hole
30: Wiring substrate
101: Offset surface
102: Opposite surface
103: First side surface
104: Second side surface
200: Inspection pad

## Claims

1. An electrical connection apparatus used for measuring electrical characteristics of an inspection object, comprising:
a plurality of probes arranged in such a way that each tip end comes into contact with a plurality of inspection pads of the inspection object; and
a probe head having a configuration in which a first guide plate and a second guide plate, each having a guide hole formed therein, are arranged apart from each other along a surface normal direction of a main surface of the first guide plate, and holding the probes in a state in which the probes penetrate through the guide hole of the first guide plate and the guide hole of the second guide plate, wherein
positions of the guide hole of the first guide plate and the guide hole of the second guide plate through which the same probe penetrates are arranged in an offset manner so as to be shifted parallel to the main surface of the first guide plate, and
an offset direction in which the positions of the guide holes arranged in the offset manner are shifted intersects obliquely with an arrangement direction of the inspection pads.

2. The electrical connection apparatus according to claim 1,
wherein liner sides perpendicular to the offset direction are included in a cross-sectional shape of the guide hole viewed from a surface normal direction of the main surface of the first guide plate.

3. The electrical connection apparatus according to claim 1,
wherein a longitudinal direction in a cross-sectional shape of the guide hole viewed from a surface normal direction of the main surface of the first guide plate is perpendicular to the offset direction.

4. The electrical connection apparatus according to claim 1,
wherein the inspection pads are arranged in a matrix along a first direction and a second direction orthogonal to the first direction, and the offset direction intersects obliquely with both the first direction and the second direction.

5. The electrical connection apparatus according to any one of claims 1 to 4,
wherein the probe has a plurality of insulating covering materials arranged on a surface of the probe such that the covering materials are arranged apart from each other along a central axis direction of the probe.

6. The electrical connection apparatus according to claim 5, wherein
the probe head holds the probes curved in the offset direction in a hollow portion between the first guide plate and the second guide plate, and
the covering materials are arranged at least in curved portions of the probes.

7. The electrical connection apparatus according to claim 5, wherein
a cross-section of the probe perpendicular to the central axis direction has a rectangular shape defined by an offset surface facing the offset direction of the probe, an opposite surface opposite to the offset surface, a first side surface and a second side surface which are connected to the offset surface and the opposite surface, and
the covering material is continuously arranged from the first side surface through the offset surface to the second side surface.

8. The electrical connection apparatus according to claim 5,
wherein a sum of an outer diameter of the probe and a thickness of the covering material is set smaller than an inner diameter of the guide hole.
